# EUROPÄISCHE PATENTSCHRIFT

(11) **EP 1 388 592 B1**
(45) Veröffentlichungstag und Bekanntmachung des Hinweises auf die Patenterteilung: **25.08.2010**
(21) Anmeldenummer: 03405486.6
(22) Anmeldetag: 01.07.2003
(51) Int. Cl.: C23C 8/04, C23C 10/04, C23C 14/04, C23C 16/04

(54) **Verfahren und Vorrichtung zur Isolierung eines Oberflächenbereichs eines Werkstücks**
Process and apparatus for isolating a surface area of a workpiece
Procédé et installation d'isolement d'une zone superficielle d'une pièce

(30) Priorität: 31.07.2002 EP 02405670
(43) Veröffentlichungstag der Anmeldung: 11.02.2004
(73) Patentinhaber: Bode, Hilmar, 38228 Salzgitter (DE)
(72) Erfinder: Bode, Hilmar, 38228 Salzgitter (DE)
(74) Vertreter: Lins, Edgar

(56) Entgegenhaltungen:
- EP-A- 0 416 813
- EP-A- 0 863 288
- WO-A-90/10809
- DE-A- 10 107 810
- DE-B- 1 053 013
- JP-A- 60 204 879
- US-A- 2 179 073
- US-A- 3 320 084
- US-A- 3 631 837
- US-A- 3 740 259
- US-A- 4 617 202
- US-A- 4 745 878
- US-A- 5 691 018
- US-A- 5 792 267
- US-B1- 6 176 934
- US-B1- 6 224 673
- US-B1- 6 238 489
- PATENT ABSTRACTS OF JAPAN vol. 1998, no. 12, 31. Oktober 1998 (1998-10-31) & JP 10 195633 A (SONY CORP), 28. Juli 1998 (1998-07-28)
- PATENT ABSTRACTS OF JAPAN vol. 009, no. 066 (C-271), 26. März 1985 (1985-03-26) & JP 59 197558 A (MAZDA KK), 9. November 1984 (1984-11-09)

## Beschreibung

Die Erfindung betrifft ein Verfahren zur Oberflächenbehandlung eines Kugelzapfens gemäss dem Oberbegriff von Anspruch 1.

Es ist bekannt, beanspruchte Oberflächen, insbesondere Oberflächen von metallischen Werkstücken, durch ganz unterschiedliche Verfahren zu veredeln. Eine Veredelung kann unter anderem beispielsweise durch das Aufbringen einer Schutzschicht aus Farbe, durch Verchromen, Verzinken, oder durch Aufbringen einer Oxid- oder einer keramischen Schicht erreicht werden. Häufig kann insbesondere das Korrosions- und Verschleissverhalten von stark beanspruchten Werkstücken aus Eisenbasiswerkstoffen verbessert werden, indem die Oberflächenschicht des Werkstücks geeignet modifiziert wird. Besonders bewährt haben sich hier Verfahren, bei welchen der Gefügezustand der Oberfläche eines Werkstücks auf Eisenbasis durch eine Stickstoff- und / oder Kohlenstoffanreicherung mit eventuell nachfolgender Oxidation mit dem Ziel verändert wird, das Festigkeitsverhalten bei statischer und schwingender Beanspruchung, und / oder das Verschleissverhalten, das Formveränderungsverhalten und das Korrosionsverhalten der Oberfläche des Werkstücks zu verbessern. Bewährte Verfahren dieser Art sind beispielsweise Gas- oder Flüssignitrierverfahren oder Plasmanitrierverfahren oder auch eine Kombination der zuvor erwähnten Verfahren und insbesondere Nitrocarburierprozesse oder Salzbadnitrierverfahren, die verbreitet zum Veredeln, Härten und zum Korrionsschutz oder zur Verbesserung des tribologischen Verhaltens beanspruchter Oberflächen Verwendung finden.

Dabei tritt häufig das Problem auf, dass nur ein Teil der Oberfläche eines Werkstücks, beispielsweise in einer Gasatmosphäre oder in einem Flüssigkeitsbad behandelt werden soll und ein bestimmter Teil einer Oberfläche nicht.

So ist es seit langem bekannt, die Oberfläche von Kugelzapfen für Fahrwerksysteme, beispielsweise für Querlenker von Kraftfahrzeugen, in einem Gas-Nitrocarburierungsprozess oder in einem Flüssigkeitsbad durch Salzbadnitrieren zu veredeln. Solche Kugelzapfen sind Werkstücke, die im wesentlichen aus einem annähernd zylinderförmigen Schaft bestehen, der an einem Ende über einen gewissen Bereich ein Gewinde aufweist, und an seinem anderen Ende als Kugel ausgebildet ist, so dass die Kugel mit einer Kugelpfanne des Fahrwerksystems formschlüssig zusammenwirken kann. Da die Kugel im Einbau- und Betriebszustand erheblichen Kräften und insbesondere auch tribologischen Belastungen ausgesetzt ist, ist es notwendig, zumindest den Oberflächenbereich der Kugel des Kugelzapfens, z.B. in einem Gas-Nitrocarburierungsprozess in einer Prozesskammer oder in einem Flüssigkeitsbad durch Salzbadnitrieren zu härten.

Bisher wurde jedoch fast immer die gesamte Oberfläche des Kugelzapfens behandelt, also insbesondere auch der Gewindebereich. Die Behandlung durch Aufstickung der Oberfläche in einem Nitrier- oder Nitrocarburierungsprozess wirkt sich jedoch im Gewindebereich negativ aus. Bei einer Aufstickung eines Oberflächenbereichs in einem Nitrierprozess bilden sich dünne Oberflächenschichten, sogenannte Verbindungsschichten, mit Dicken im Mikrometer Bereich, die, insbesondere bei transversalen Belastungen und bei Einwirkung starker Reibungskräfte, wie sie bei einer Verschraubung eines Gewindes bevorzugt auftreten, zur Bildung von Mikrorissen im Gewindebereich führen können.

Daher wurde der Gewindebereich beim Gas-Nitrocarburieren mit einer Nitrierschutzpaste abgedeckt, die mit erheblichem Aufwand nach dem Gas-Nitrierprozess wieder entfernt werden musste. Darüber hinaus ist das Abdecken eines nicht zu beschichtenden Oberflächenbereichs mit einem plastischen Medium, wie beispielsweise mit einer Nitrierschutzpaste, für viele Beschichtungsverfahren völlig ungeeignet. So kann sich eine Schutzpaste beim Salzbadnitrieren in der Flüssigkeit des Nitrierbades auflösen, wodurch das Nitrierbad einerseits verschmutzt wird und andererseits die Schutzfunktion für die Oberfläche verloren geht. Aber auch bei Verfahren zur Oberflächenbehandlung, die in einer Prozesskammer unter Unterdruckbedingungen, wie beispielsweise bei bekannten PVD-Verfahren (Physical Vapour Deposition) durchgeführt werden müssen, ist die Verwendung von Schutzpasten zur Abdeckung nicht zu beschichtender Oberflächenbereiche in der Regel nicht wünschenswert, da die Schutzpaste aufgrund ihres Dampfdrucks in erheblichem Maße abdampfen kann, so dass einerseits nur mit großem Aufwand der notwendige Unterdruck in der Prozesskammer aufrecht erhalten werden kann und andererseits durch Abdampfen der Schutzpaste die zu schützenden Oberflächenbereiche frei gegeben werden.

Aus der US 6224,673 B1 sind eine Vorrichtung und ein Verfahren zum Maskieren von Turbinenkomponenten während eines Gasphasen-Diffusionsbeschichtens bekannt. Zum Maskieren des Sockels von Turbinenschaufeln wird ein Hohlraum verwendet, auf den die Turbinenschaufel mit ihrer rechteckigen Grundfläche aufgesetzt wird. Sofern notwendig, wird der Hohlraum über Dichtmittel, wie beispielsweise ein Siegelmittel, gegenüber der Beschichtungs-Atmosphäre abgedichtet.

Aus der DE 1 053 013 ist ein Verfahren zur Verhinderung oder Regulierung der Kohlenstoffaufnahme bei der Pulver- oder Gasaufkohlung bekannt. Dabei wird ein zu schützender Bereich eines Werkstücks in einen Hohlraum eingebracht. In dem Hohlraum befindet sich ein Sauerstoff abgebendes Substrat. Beim Aufkohlen mit Kohlenmonoxyd wird in den Hohlraum ein diffundierendes Kohlenmonoxyd oxydiert, so dass es den geschützten Bereich nicht aufkohlen kann.

Aus der US 2,179,073 ist ein Verfahren zum Aufkohlen von metallischen Gegenständen bekannt. Bei diesem Verfahren wird der zu härtende Gegenstand In eine Hülse eingebracht und anschließend mit einem Kohlenstoffspender umgeben.

Aus der WO 021066698 ist eine Vorrichtung zum partiellen Aufkohlen von Bauteilen bekannt. Diese Vorrichtung umgibt das zu schützende Bauteil teilweise und mit einem sehr engen Spalt, Das Hülsenmaterial besitzt einen kleineren thermischen Ausdehnungskoeffizienten als das Material des zu schützenden Bauteils, so dass bei einer Erwärmung der Spalt geschlossen und ein Eindiffundieren von Aufkpohlungsgas verhindert wird.

Aus der US 3,740,259 und der US 3,631,837 sind Verfahren zum Beschichten oder Lackieren von Behältern bekannt. Um Teile des Behälters, beispielsweise in der Nähe eines Ausgusses, vor Farbe oder Beschichtungsmaterial zu schützen, wird der Behälter vor dem Beschichten auf eine Schutzhülse aufgeschraubt.

Aus der JP 60-204 879 ist ein Verfahren zum Schützen eines Bauteils gegenüber einer Atmosphäre bekannt, bei dem das Bauteil durch eine enge Öffnung in einen Hohlraum eingeführt wird. Beim Erhitzen von Hülse und Bauteil dehnen sich beide unterschiedlich aus, so dass etwaig verbliebene Spalte geschlossen werden.

Aus der WO 90/10809, der EP 0 863 288 A2 und der US 6,176,934 sind weitere Dichtungen bekannt.

Es ist daher die Aufgabe der Erfindung, ein einfaches Verfahren zur teilweisen Oberflächenbehandlung vorzuschlagen, das auch bei Unterdruck sicher in der Prozesskammer angewandt werden kann.

Die Erfindung löst das Problem durch ein Verfahren gemäß Anspruch 1.

Die jeweiligen abhängigen Ansprüche beziehen sich auf besonders vorteilhafte Ausführungsformen der Erfindung.

Geeignet zur Durchführung eines erfindungsgemäßen Verfahrens ist eine im folgenden vorgeschlagene Vorrichtung zur Isolierung eines Oberflächenbereichs eines Werkstücks von einem fluiden Medium. Die Vorrichtung weist einen Hohlraum mit einer Öffnung zur Aufnahme des Werkstücks auf, wobei Mittel zur Abdichtung des Hohlraums vorgesehen sind, so dass während einer Oberflächenbehandlung des Werkstücks ein Eindringen des fluiden Mediums in den Hohlraum verhinderbar ist.

Die Vorrichtung weist somit einen Hohlraum mit einer Öffnung auf, welcher Hohlraum vorzugsweise in einer metallischen Abdeckhülse vorgesehen ist, wobei die Abdeckhülse selbstverständlich auch aus einem anderen geeigneten Material, beispielsweise aus einem Kunststoff, einem keramischen Material oder einem glasartigen Material aufgebaut sein kann. Der Hohlraum der Vorrichtung ist dabei jeweils so ausgestaltet, dass er einen Teil eines Werkstücks aufnehmen kann, dessen Oberflächenbereich bei einer Oberflächenbehandlung des Werkstücks nicht behandelt werden soll. Dazu sind bevorzugt an der Öffnung des Hohlraums Mittel zur Abdichtung des Hohlraums vorgesehen, die ein Dichtelement, insbesondere einen Dichtring umfassen, der im Bereich der Öffnung des Hohlraums so ausgestaltet und angeordnet ist, dass er mit einem äusseren Umfang des Werkstücks dichtend zusammenwirken kann, so dass der Hohlraum und damit der Bereich der Oberfläche des Werkstücks, der innerhalb des Hohlraums angeordnet ist, von einem fluiden Medium ausserhalb des Hohlkörpers isoliert ist. Dabei ist es durchaus möglich, dass der Hohlraum im Bereich der Öffnung mittels eines plastisch verformbaren Mediums, insbesondere mittels einer Nitrierschutzpaste, an einem äusseren Umfang des Werkstücks abgedichtet wird. Dabei kann die Nitrierschutzpaste das Dichtelement in seiner dichtenden Wirkung unterstützen, oder sogar allein die Funktion eines Mittels zur Abdichtung des Hohlraums im Bereich der Öffnung übernehmen.

Dabei können die Mittel zur Abdichtung auch durch eine thermische Dehnung des Hohlkörpers und / oder des Dichtelements realisiert sein. Beispielsweise kann als Material für den Hohlkörper und / oder für das Dichtelement ein Material gewählt werden, das einen anderen thermischen Ausdehungskoeffizienten aufweist, als das Material des Werkstücks. Findet die Oberflächenbehandlung des Werkstücks bei einer Behandlungstemperatur statt, die von der Raumtemperatur abweicht, beispielsweise bei einer Behandlungstemperatur deutlich oberhalb oder unterhalb der Raumtemperatur, können, bei geeigneter Anordnung des Werkstücks in der entsprechend ausgestalteten Öffnung des Hohlraum der erfindungsgemässen Vorrichtung, das Werkstück und / oder das Dichtelement und die Öffnung des Hohlraums derart formschlüssig zusammenwirken, dass sich aufgrund der unterschiedlichen thermischen Ausdehnungskoeffizienten bei Abweichung von der Raumtemperatur eine entsprechende Dichtwirkung ergibt.

Erfindungsgemäß ist das Werkstück ein Kugelzapfen, der in an sich bekannter Weise einen Schaft mit Gewinde und einen Kugelabschnitt umfasst, welcher Kugelabschnitt mit einer Kugelpfanne formschlüssig zusammenwirken kann. Zur Verbesserung der Härte und / oder der tribologischen oder anderer Eigenschaften der Oberfläche des Kugelabschnitts, wird dessen Oberfläche bevorzugt in einem Reaktionsgefäss in einem gasförmigen oder flüssigen Fluid nitriert, das heisst die Oberfläche wird durch Aufstickung veredelt. Insbesondere findet der Aufstickungsprozess der Oberfläche in einer Gasatmosphäre nach einem an sich bekannten Verfahren durch Nitrocarburierung statt. Erfindungsgemäß werden die zuvor genannten Verfahren in einem Temperaturbereich zwischen 350°C und 900°C, vorzugsweise zwischen 500°C und 600°C, durchgeführt. Um zu vermeiden, dass auch die Oberfläche im Gewindebereich des Kugelzapfens einer Aufstickung durch Nitrierung unterzogen wird, wird der Gewindebereich des Kugelzapfens im Hohlraum der Vorrichtung angeordnet, wobei die Vorrichtung in einer bevorzugten Ausführungsform an der Öffnung des Hohlraum als Dichtelement einen elastisch oder plastisch verformbaren O-Ring aufweist, der so ausgestaltet und angeordnet ist, dass er mit einem äusseren Umfang des Schaftes des Kugelzapfens dichtend zusammenwirkt. Selbstverständlich kann die Vorrichtung in analoger Weise zur teilweisen Beschichtung einer Oberfläche eines beliebigen Werkstücks, auch eines nicht-metallischen Werkstücks verwendet werden, wobei der Hohlraum und die Öffnung der Vorrichtung zur Aufnahme des Werkstücks entsprechend ausgestaltet sind.

In einem anderen Ausführungsbeispiel umfasst die zur Durchführung des erfindungsgemäßen Verfahrens geeignete Vorrichtung eine Zusatzeinrichtung zum Unterstützen der Abdichtfunktion des Dichtelements. Hierbei kann es sich insbesondere um eine mechanische, eine pneumatische oder eine hydraulische Zusatzeinrichtung handeln. In Frage kommen zum Beispiel einfache mechanische Zusatzeinrichtungen wie ein Spannring, der es erlaubt das Dichtelement an einen äusseren Umfang des Werkstücks anzupressen.

Dabei kann die Vorrichtung auch pneumatische oder hydraulische Zusatzeinrichtungen umfassen. Beispielsweise kann das Dichtelement einen hohlen elastisch dehnbahren Schlauch umfassen, der über ein Leitungssystem mit einer hydraulischen oder pneumatischen Versorgungseinrichtung verbunden ist, die das Dichtelement über ein fluides Druckmedium, dass dem Dichtelement über das Leitungssystem zugeführt werden kann, derart mit einem Arbeitsdruck beaufschlagt , dass der elastisch dehnbare Schlauch formgerecht an einen äusseren Umfang des Werkstücks anpressbar ist, wodurch die Dichtwirkung erhöht werden kann. Dabei kommen als Materialien für den elastischen Schlauch bevorzugt Hochtemperaturwerkstoffe, wie Hochtemperaturkunststoffe, beispielsweise Kohlefaserverstärkte Werkstoffe wie PEEK (Polyetheretherketon) oder auch andere geeignete Werkstoffe in Frage. Insbesondere kann der elastische Schlauch bei geeigneter Ausgestaltung auch aus einem metallischen Werkstoff aufgebaut sein. Ein mit Arbeitsdruck beaufschlagbares Dichtelement kann insbesondere dann von Vorteil sein, wenn in der Prozesskammer, wie beispielsweise in einer lonisierungskammer, ein bedeutender Unterdruck herrscht, so dass ohne unterstützende Zusatzeinrichtung die Dichtwirkung des Dichtelementes nicht ausreicht.

Dabei ist in einem bevorzugten Ausführungsbeispiel der elastisch dehnbare Schlauch so angeordnet und ausgeführt, dass das Werkstück, solange der Schlauch nicht vom Arbeitsdruck des fluiden Druckmediums beaufschlagt ist, ohne wesentlichen Kraftaufwand durch die Öffnung in den Hohlraum der Vorrichtung eingebracht werden kann und der elastisch dehnbare Schlauch erst bei Beaufschlagung mit Arbeitsdruck formschlüssig und dichtend an das Werkstück angepresst wird.

Wie bereits erwähnt, erfolgt die Oberflächenbehandlung des Werkstücks in der Regel in einem Reaktionsraum oder in einer Prozesskammer. Die Prozesskammer kann dabei eine oder mehrere Chargiereinrichtungen umfassen, die Halterungen zur Aufnahme eines oder mehrerer Werkstücke aufweist, wobei an der Vorrichtung Einrichtungen zur Fixierung der Vorrichtung in einer Halterung vorgesehen sind. Wenn die Vorrichtung wie oben beschrieben eine pneumatische oder hydraulische Zusatzeinrichtung umfasst, erfolgt die Beaufschlagung einer oder mehrerer Vorrichtungen mit Arbeitsdruck bevorzugt zentral von einer Versorgungseinrichtung über ein Verteilsystem, das über ein Leitungssystem mit den auf der Chargiereinrichtung in der Prozesskammer angeordneten Vorrichtungen verbunden ist.

Erfindungsgemäss wird ein Verfahren zur Oberflächenbehandlung eines Werkstücks mittels einer Vorrichtung zur Isolierung eines Oberflächenbereichs des Werkstücks von einem fluiden Medium vorgeschlagen. Bei dem Verfahren wird das Werkstück teilweise durch eine Öffnung in einen Hohlraum der Vorrichtung eingebracht und mit Mitteln zur Abdichtung der Hohlraum abgedichtet. Dadurch wird während der Oberflächenbehandlung des Werkstücks ein Eindringen des fluiden Mediums in den Hohlraum verhindert.

Dabei umfasst das erfindungsgemässe Verfahren zur Oberflächenbehandlung eines Werkstücks ein Verfahren bei welchem ein Bereich der Oberfläche des Werkstücks nitriert oder nitrocarburiert wird, insbesondere durch einen Gas-Nitrierprozess.

Im folgenden wird die Erfindung anhand der Zeichnung näher erläutert. Es zeigen in schematischer Darstellung:
- Fig. 1: eine zur Durchführung des erfindungsgemäßen Verfahrens geeignete Vorrichtung mit einem Werkstück;
- Fig. 2: einen Längsschnitt durch eine zur Durchführung des erfindungsgemäßen Verfahren geeignete Vorrichtung mit Dichtelement;
- Fig. 3: wie Fig. 2 mit Zusatz- und Versorgungseinrichtung.

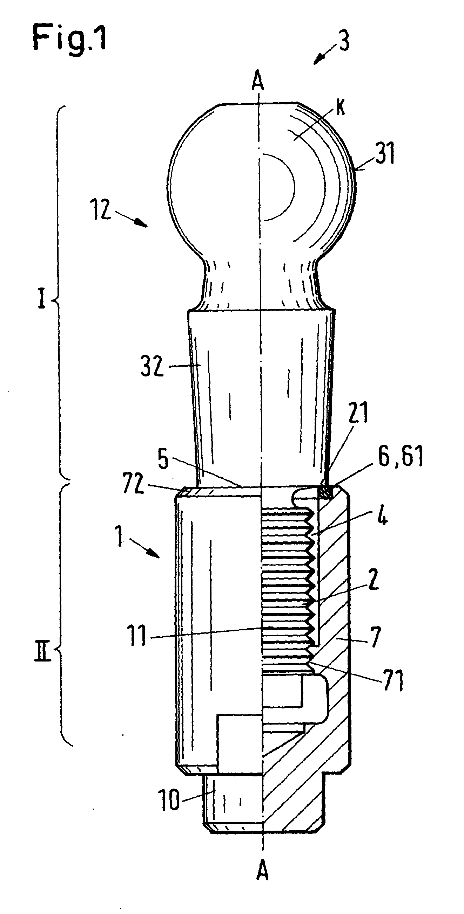

Fig. 1 zeigt ein Ausführungsbeispiel einer Vorrichtung, die im folgenden gesamthaft mit dem Bezugszeichen 1 bezeichnet wird, zusammen mit einem Kugelzapfen 3 für ein Fahrwerksystem, das in Fig. 1 beispielhaft für ein Werkstück 3 dargestellt ist. Selbstverständlich gelten die nachfolgenden Ausführungen analog für ein beliebiges Werkstück 3, das auch aus einem nicht metallischen Werkstoff aufgebaut sein kann.

Die Vorrichtung 1 umfasst eine bevorzugt metallische Abdeckhülse 7 mit einem Hohlraum 4, der geeignet ist ein Werkstück 3 teilweise aufzunehmen. Das Werkstück 3 umfasst einen Abschnitt l, dessen Oberfläche durch Einwirkung eines fluiden Mediums behandelt wird, sowie einen Abschnitt II, dessen Oberflächenbereich 2 nicht behandelt werden soll. In dem hier gezeigten Beispiel soll der Kugelzapfen 3, der im wesentlichen einen zylindrischen Schaft 32 mit Kugel K und ein Gewinde 11 umfasst, vornehmlich in einem Bereich 31 der Oberfläche der Kugel K behandelt werden, während der Oberflächenbereich 2 des Kugelzapfens 3 im Abschnitt II, der im wesentlichen ein Gewinde 11 des Kugelzapfens 3 umfasst, nicht behandelt werden soll. Um dies zu erreichen ist der Bereich II des Gewindes 11 des Kugelzapfens 3 im Hohlraum 4 der Abdeckhülse 7 angeordnet. Bevorzugt ist der Kugelzapfen 3 in der Abdeckhülse 7 mit dem Gewinde 11 in einer Gewindebohrung 71 fixiert. Dabei weist die Öffnung 5 der Abdeckhülse 7 Mittel 6 zur Abdichtung des Hohlraums 4 der Abdeckhülse 7 auf, die ein Dichtelement 61 umfassen, das bevorzugt als Dichtring ausgebildet ist. Der Dichtring ist dabei im Bereich der Öffnung 5 des Hohlraums 4 so angeordnet und ausgebildet, dass er mit einem äusseren Umfang 21 des Kugelzapfens 3 dichtend zusammenwirkt. Beispielsweise kann das Dichtelement 61 als elastischer Ring, insbesondere als O-Ring aus einem geeigneten Kunststoff ausgestaltet sein. Dabei kann das Dichtelement 61, wie später noch erläutert wird, über in Fig. 1 nicht gezeigte Zusatzeinrichtungen 62 zum Unterstützen der Abdichtfunktion des Dichtelements 61 verfügen, die die Abdichtwirkung erhöhen bzw. das Entfernen der Abdeckhülse 7 nach der Oberflächenbehandlung erleichtern. In Frage kommen zum Beispiel einfache mechanische Einrichtungen wie ein Spannring oder ein Spannband, das es erlaubt, das Dichtelement 61 an den äusseren Umfang 21 des Werkstücks 3 anzupressen. Dabei können die Mittel 6 zur Abdichtung auch durch eine thermische Dehnung der Abdeckhülse 7 und / oder des Dichtelements 61 realisiert sein. Beispielsweise kann als Material für die Abdeckhülse 7 ein Material gewählt werden, das einen grösseren thermischen Ausdehungskoeffizienten aufweist, als das Material des Werkstücks 3, also hier des Kugelzapfens 3. Die Oberflächenbehandlung des Kugelzapfens 3 findet bei einer Behandlungstemperatur statt, die erheblich über der Raumtemperatur liegt, nämlich bei einer Behandlungstemperatur zwischen 350° C und 900° C, Daher dehnt sich die Abdeckhülse 7 bei Erwärmung von Raumtemperatur auf die Behandlungstemperatur in Richtung einer axial verlaufenden Längsachse A - A stärker als der Kugelzapfen 3. Da der Kugelzapfen 3 mit dem Gewinde 11 in der Abdeckhülse 7 in der Gewindebohrung 71 fixiert ist, wird aufgrund der unterschiedlichen thermischen Dehnung von Abdeckhülse 7 und Kugelzapfen 3 ein Randbereich 72 der Öffnung 5 der Abdeckhülse 7 gegen den Schaft 32 gepresst, wodurch der Hohlraum 4 abgedichtet wird. Das heisst, durch die unterschiedliche thermische Ausdehnung von Kugelzapfen 3 und / oder Abdeckhülse 7 und / oder Dichtelement 61 kann die Dichtwirkung des Dichtelements 61 erhöht werden.

Üblicherweise erfolgt die Oberflächenbehandlung des Kugelzapfens 3 in einer nicht gezeigten Prozesskammer, in der in der Regel Halterungen, die insbesondere einer Chargiervorrichtung zugeordnet sein können, zur Aufnahme von ein oder mehreren Kugelzapfen vorgesehen sind. Die Vorrichtung 1 weist daher Einrichtungen 10 zur Fixierung der Vorrichtung 1 in der Halterung auf. Die Einrichtung 10 kann insbesondere eine Verschraubung oder einen Bajonettverschluss oder andere geeignete Mittel zur Fixierung der Vorrichtung 1 in der Halterung aufweisen.

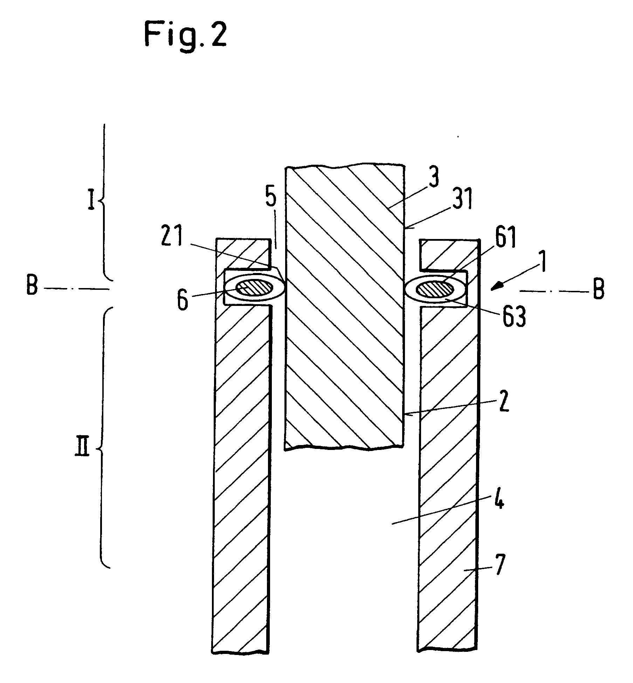

In Fig. 2 ist schematisch ein Längsschnitt durch eine Vorrichtung 1 dargestellt. Die Vorrichtung 1 umfasst die Abdeckhülse 7 in welcher ein Abschnitt II des Werkstück 3 untergebracht ist. Weiter weist das Werkstück 3 einen Abschnitt l auf, dessen Oberfläche 31 einer Oberflächenbehandlung mittels eines fluiden Mediums unterzogen werden soll, während der Oberflächenbereich 2 des Abschnitt II nicht behandelt werden soll. Es sind Mittel 6 zur Abdichtung des Hohlraums 4 vorgesehen, welche Mittel 6 als Dichtelement 61 ausgeführt ist, das im Bereich der Öffnung 5 des Hohlraums 4 so angeordnet und ausgestaltet ist, dass es mit einem äusseren Umfang 21 des Werkstücks 3 dichtend zusammenwirken kann. Das Dichtelement 61 ist dabei bevorzugt als metallischer Dichtring, beispielsweise aus Weicheisen, Kupfer, Aluminium, Messing oder einer anderen Legierung, ausgeführt sein und kann beispielsweise als O-Ring im Einbauzustand den Umfang 21 des Werkstücks 3 dichtend umschliessen. Selbstverständlich kann das Dichtelement 61 auch aus anderen Materialien, beispielsweise aus einem geeigneten Kunststoff, insbesondere aus einem Hochtemperaturkunststoff, wie Kohlefaserverstärkten Werkstoffen wie zum Beispiel PEEK (Polyetheretherketon), oder auch aus eisenmetallischen Werkstoffen, wie zum Beispiel Stahl, oder aus einem keramischen Werkstoff oder jedem anderen geeigneten Material aufgebaut sein. Das Dichtelement 61 kann selbstverständlich auch einen dichtenden Metallring umfassen, der beispielsweise zur Erhöhung der Dichtfunktion eine Beschichtung 63 aufweisen kann, welche Beschichtung 63 ein geeignetes Material, beispielsweise eine der zuvor erwähnten Materialien, oder je nach Anwendung ein plastisch verformbares Medium, wie beispielsweise ein plastisch verformbares Metall, oder eine Paste, insbesondere eine Nitrierschutzpaste, umfasst. Selbstverständlich können auch nicht-metallische Dichtelemente 61 eine Beschichtung 63 aufweisen. Dabei können die Mittel 6 zur Abdichtung auch durch eine thermische Dehnung der Abdeckhülse 7 und des Dichtelements 61 realisiert sein. Beispielsweise kann als Material für die Abdeckhülse 7 ein Material gewählt werden, das einen kleineren thermischen Ausdehungskoeffizienten aufweist, als das Material des Werkstücks 3. Findet die Oberflächenbehandlung des Kugelzapfens 3 bei einer Behandlungstemperatur statt, die erheblich über der Raumtemperatur liegt, wie bei einer Behandlungstemperatur zwischen 350° C und 900° C, so dehnt sich die Abdeckhülse 7 bei Erwärmung von Raumtemperatur auf die Behandlungstemperatur in Richtung einer radial verlaufenden Querschnittsachse B - B weniger stark, als sich das Werkstück 3 in der entsprechenden Richtung dehnt. Damit wird aufgrund der unterschiedlichen thermischen Dehnung von Abdeckhülse 7 und Werkstück 3 der äussere Umfang 21 des Werkstücks 3 gegen das Dichtelements 61 gepresst, wodurch die Dichtwirkung des Dichtelements 61 erhöht werden kann. Insbesondere kann beispielsweise auch das Dichtelement 61 einen anderen Wert, insbesondere einen grösseren Wert des Ausdehnungskoefizienten aufweisen, als das Werkstück 3 und / oder die Abdeckhülse 7, so dass das Dichtelement bei Temperaturerhöhung dichtend gegen den Umfang 21 des Werkstücks 3 und die Abdeckhülse 7 gepresst wird.

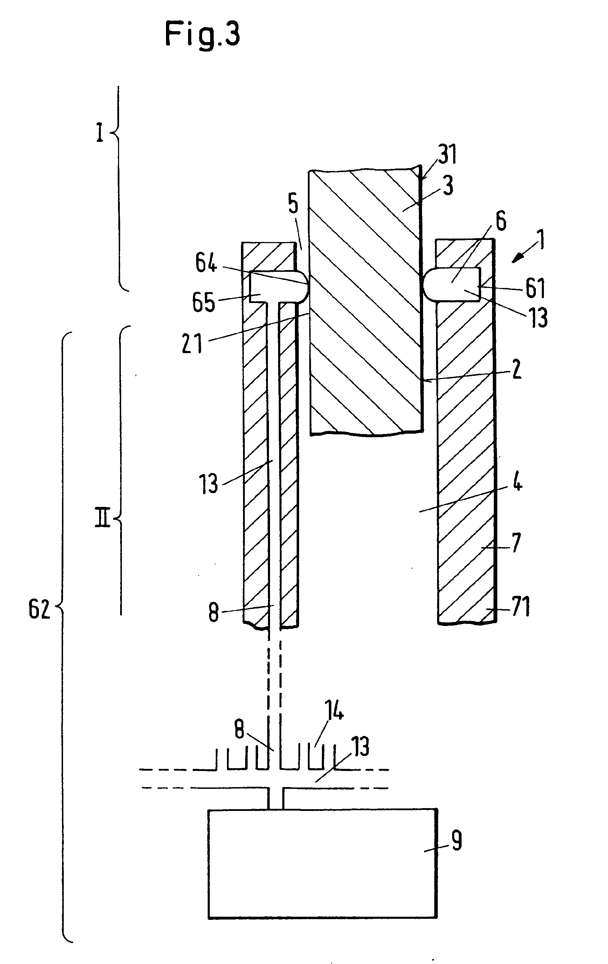

In Fig. 3 ist ein weiteres Ausführungsbeispiel einer zur Durchführung eines erfindungsgemäßen Verfahrens geeignete Vorrichtung 1 schematisch dargestellt, die eine Zusatzeinrichtung 62 zum Unterstützen der Abdichtfunktion des Dichtelements 61 umfasst, insbesondere eine pneumatische oder eine hydraulische Zusatzeinrichtung 62. Die Vorrichtung 1 umfasst die Abdeckhülse 7 in welcher ein Abschnitt II eines Werkstück 3 untergebracht ist. Weiter weist das Werkstück 3 einen Abschnitt l auf, dessen Oberfläche 31 einer Oberflächenbehandlung mittels eines fluiden Mediums unterzogen werden soll, während der Oberflächenbereich 2 des Abschnitt II nicht behandelt werden soll. Die Mittel 6, die zur Abdichtung an der Öffnung 5 des Hohlraums 4 vorgesehen sind, sind als Dichtelement 61 mit einem Hohlbereich 65 ausgeführt, wobei das Dichtelement 61 einen elastisch dehnbaren Bereich 64 aufweist.

In einer Ausführungsform ist der Hohlbereich 65 als abgeschlossener elastisch dehnbarer hohler Ringkörper ausgeführt, der mit einem Fluid, beispielsweise mit Luft, ausgefüllt ist. Dabei ist Ringkörper so ausgeführt, dass der Ringkörper aufgrund der Wärmeausdehnung des Fluids bei einer Temperaturerhöhung mit einem Innendruck derart beaufschlagt wird, dass sich der elastisch dehnbare Ringkörper formgerecht an den äusseren Umfang 21 des Werkstücks anpresst, wodurch die Dichtwirkung des Dichtelements 61 zur Abdichtung des Hohlraums 4 erhöht wird. Ein solcher Ringkörper kann selbstverständlich auch in einer Prozesskammer erfolgreich eingesetzt werden, die gegenüber dem Innendruck des Ringkörpers einen Unterdruck aufweist, so dass aufgrund der Druckdifferenz der elastisch dehnbare Ringkörper formgerecht an den äusseren Umfang 21 des Werkstücks angepresst wird, wodurch die Dichtwirkung des Dichtelements 61 zur Abdichtung des Hohlraums 4 erhöht wird.

Das Dichtelement 61 mit Hohlbereich 65 kann auch als elastisch dehnbarer Schlauch ausgeführt sein, wobei der Hohlbereich 65 über ein Leitungssystem 8 mit einem Arbeitsdruck eines fluiden Druckmediums 13 beaufschlagbar ist, so dass der elastisch dehnbare Bereich 64 des Dichtelements 61 bzw. der elastisch dehnbare Schlauch formgerecht an den äusseren Umfang 21 des Werkstücks anpressbar ist, wodurch die Dichtwirkung des Dichtelements 61 zur Abdichtung des Hohlraums 4 erhöht wird. Der Hohlbereich 65, ist durch das Leitungssystem 8 mit einer hydraulischen oder pneumatischen Versorgungseinheit 9 verbunden, die insbesondere ein Verteilsystem 14 umfasst, welches dazu geeignet ist, die ein oder mehrere Vorrichtungen 1 mit dem fluiden Druckmedium 13 zu versorgen und mit einem Arbeitsdruck zu beaufschlagen.

Durch Verwendung der genannten Vorrichtung ist es auf besonders einfache Weise möglich, eine Oberflächenbehandlung eines Werkstücks in einem fluiden Medium durchzuführen, wobei ein vorgebbarer Teil der Oberfläche des Werkstücks von der Behandlung ausgenommen wird. So kann die Vorrichtung beispielsweise besonders erfolgreich zur Behandlung der Oberfläche einer Kugel eines Kugelzapfens in einem Nitrier- oder Nitrocarburierungsprozess eingesetzt werden, bei welchen eine Oberflächenbehandlung des Gewindebereich zu vermeiden ist. Dadurch wird die Ausbildung von sogenannten Verbindungsschichten im Gewindebereich unterbunden, die, insbesondere bei transversalen Belastungen und bei Einwirkung starker Reibungskräfte, wie sie bei einer Verschraubung eines Gewindes bevorzugt auftreten, zur Bildung von Mikrorissen im Gewindebereich führen können.

Die aus dem Stand der Technik bekannte Abdeckung des Gewindebereich mit einer Nitrierpaste, die mit erheblichen Aufwand nach dem Gas-Nitrierprozess wieder entfernt werden muss, entfällt durch Verwendung der beschriebenen Vorrichtung. Darüber hinaus kann die hier vorgeschlagene Vorrichtung auch bei Beschichtungsverfahren problemlos eingesetzt werden, bei denen eine Teilabadeckung der Oberfläche mit einer Nitrierpaste oder einem anderen plastischen fluiden Medium nicht möglich ist. Durch Zusatzeinrichtungen, insbesondere durch pneumatische oder hydraulische Zusatzeinrichtungen, kann die Dichtwirkung der Mittel zum Abdichten erhöht werden, bzw. kann durch Beaufschlagung der Zusatzeinrichtungen mit einem Arbeitsdruck die Dichtwirkung der Mittel zum Abdichten über eine zentrale Versorgungseinrichtung gesteuert und / oder geregelt werden.

## Patentansprüche

1. Verfahren zur Oberflächenbehandlung eines Kugelzapfens (12) mittels einer Vorrichtung zur Isolierung eines Oberflächenbereichs (2) des Kugelzapfens (12) von einem gasförmigen Medium, bei welchem Verfahren
(a) der Kugelzapfen (12) teilweise durch eine Öffnung (5) in einen Hohlraum (4) der Vorrichtung eingebracht wird und
(b) mit Mitteln (6) zur Abdichtung der Hohlraum abgedichtet wird, so dass während der Oberflächenbehandlung des Kugelzapfens (12) ein Eindringen des Mediums in den Hohlraum (4) verhindert wird,
**dadurch gekennzeichnet, dass**
(c) als Vorrichtung zur Isolierung eine Abdeckhülse (7) verwendet wird, die ein Dichtelement (61), das im Bereich der Öffnung (5) des Hohlraums (4) angeordnet ist, umfasst,
(d) wobei das Werkstück (3) mittels eines Gewindes (11) in einer Gewindebohrung (71) der Abdeckhülse (7) fixiert wird, wobei das Dichtelement (61) mit einem äußeren Umfang (21) des Kugelzapfens (12) dichtend zusammenwirkt und
(e) wobei ein Bereich (31) der Oberfläche des Kugelzapfens (12)
(i) bei einer Temperatur zwischen 350°C und 900°C
(ii) durch einen Gas-Nitrierprozess und/oder einen Plasmanitrierprozess nitriert oder nitrocarburiert wird.

2. Verfahren nach Anspruch 1, bei welchem der Bereich (31) der Oberfläche des Kugelzapfens (12) zusätzlich oxidiert wird.

3. Verfahren nach einem der vorstehenden Ansprüche, **dadurch gekennzeichnet, dass** das Verfahren bei einer Temperatur zwischen 500°C und 600°C durchgeführt wird.

## Claims

1. A method for the surface treatment of a ball stud (12) by means of an apparatus that is used to isolate a surface area (2) of the ball stud (12) from a gaseous medium, in which method
(a) the ball stud (12) is partially brought into a hollow space (4) of the apparatus through an opening (5) and
(b) the hollow space is sealed with means (6) for sealing, so that a penetration of the medium into the hollow space (4) is prevented during the surface treatment of the ball stud (12),
**characterised by** the fact that
(c) a cover sleeve (7) is used as an apparatus for isolation that comprises a sealing element (61), which is placed in the area of the opening (5) of the hollow space (4),
(d) the work piece (3) being fixed by means of a thread (11) in a threaded hole (71) of the cover sleeve (7), the sealing element (61) sealing in interaction with an outer circumference (21) of the ball stud (12) and
(e) an area (31) of the surface of the ball stud (12)
(i) at a temperature between 350°C and 900°C
(ii) is nitrided or nitrocarburised through a gas - nitriding process and /or a plasma - nitriding process.

2. The method according to claim 1 in which the area (31) of the surface of the ball stud (12) is oxidised additionally.

3. The method according to one of the preceding claims, **characterised by** the fact that the method is executed at a temperature of between 500°C and 600°C.

## Revendications

1. Procédé pour le traitement de surface d'un tenon à tête sphérique (12) au moyen d'un dispositif pour isoler une zone de surface (2) du tenon à tête sphérique (12) vis-à-vis d'un milieu gazeux, procédé dans lequel
(a) le tenon à tête sphérique (12) est introduit partiellement à travers une ouverture (5) dans une cavité (4) du dispositif et
(b) la cavité est étanchée à l'aide de moyens (6) d'étanchement de telle sorte que l'on empêche une pénétration du milieu dans la cavité (4) pendant le traitement de surface du tenon à tête sphérique (12), **caractérisé en ce que**
(c) on utilise à titre de dispositif d'isolation une douille de couverture (7) qui comprend un élément d'étanchement (61), lequel est agencé dans la région de l'ouverture (5) de la cavité (4),
(d) dans lequel la pièce à oeuvrer (3) est fixée au moyen d'un filetage (11) dans un perçage taraudé (71) de la douille de couverture (7), de sorte que l'élément d'étanchement (61) coopère de façon étanche avec une périphérie extérieure (21) du tenon à tête sphérique (12), et
(e) dans lequel une région (31) de la surface du tenon à tête sphérique (12) est nitrurée ou nitro-carburée
(i) à une température entre 350°C et 900°C
(ii) par un processus de nitruration sous gaz ou et/ou un processus de nitruration au plasma.

2. Procédé selon la revendication 1, dans lequel la région (31) de la surface du tenon à tête sphérique (12) est additionnellement oxydée.

3. Procédé selon l'une des revendications précédentes, **caractérisé en ce que** le procédé est mis en oeuvre à une température entre 500°C et 600°C.
